# EUROPEAN PATENT SPECIFICATION

(11) **EP 0 326 879 B1**
(45) Date of publication and mention of the grant of the patent: **05.04.1995**
(21) Application number: 89101009.2
(22) Date of filing: 20.01.1989
(51) Int. Cl.: H01L 29/78, H01L 27/10, G11C 17/00

(54) **Electrically-erasable, electrically-programmable read-only memory**
Elektrisch löschbare und programmierbare Nur-Lesespeicherzelle
Cellule de mémoire morte effaçable et programmable électriquement

(30) Priority: 05.02.1988 US 152790; 15.07.1988 US 219530
(43) Date of publication of application: 09.08.1989
(73) Proprietor: TEXAS INSTRUMENTS INCORPORATED, Dallas Texas 75265 (US)
(72) Inventor: Gill, Manzur, Rosharon Texas 77583 (US); Lin, Sung-Wei, Houston Texas 77083 (US); D'Arrigo, Sebastiano, Houston Texas 77071 (US)
(74) Representative: Leiser, Gottfried, Dipl.-Ing.

(56) References cited:
- EP-A- 0 105 802
- WO-A-85/01446
- US-A- 4 258 466

## Description

### BACKGROUND OF THE INVENTION

This invention relates to an electrically-erasable, electrically-programmable floating-gate memory cell according to the precharacterizing part of claim 1.

EPROMs, or electrically-programmable ROMs, are field-effect devices with a floating-gate structure. An EPROM floating gate is programmed by applying proper voltages to the source, drain and control gate of each cell, causing high current through the source-drain path and charging of the floating gate by hot electrons. The EPROM type of device is erased by ultraviolet light, which requires a device package having a quartz window above the semiconductor chip. Packages of this type are expensive in comparison with the plastic packages ordinarily used for other memory devices such as DRAMs (dynamic-random-access-memories). For this reason, EPROMs are generally more expensive than plastic-packaged devices.

EEPROMs, or electrically-erasable, electrically-programmable ROMs, have been manufactured by various field-effect-type processes, usually requiring a much larger cell size than standard EPROMs and requiring more complex manufacturing processes. EEPROMS can be mounted in opaque plastic packages that reduce the packaging cost. Nevertheless, EEPROMs have been more expensive on a per-bit basis, in comparison with EPROMs, due to larger cell size and to more complex manufacturing processes.

Flash EEPROMs have the advantage of smaller cell size in comparison with standard EEPROMs because the cells are not erased individually. Instead, the array of cells is erased in bulk.

Currently available flash EEPROMs require two power supplies, one for programming and erasing and another for reading. Typically, a 12-volt power supply is used for programming and erasing and a 5-volt power supply is used during read operations. It is desirable, however, to employ a single relatively low-voltage supply for all of the programming, erasing and reading operations.

US-A-4,258,466 shows a contactless floating gate electrically programmable memory cell and EP-A-0 105 802 discloses an electrically programmable and erasable floating-gate memory cell based on tunneling.

It is the object of this invention to provide an electrically programmable memory, or an electrically-erasable and electrically-programmable memory, that uses a single, relatively low voltage, external supply for both programming and erasing, allowing the memory device to be compatible with on-board or in-circuit programming where systems have a single external power supply. It is also an object to provide a non-volatile memory that can be packaged in a less expensive opaque plastic package. An additional object is to provide an electrically-programmable memory that does not require high current for programming. A further object is to provide an improved method of making an EEPROM or a flash EEPROM, as well as an improved cell for an EEPROM or a flash EEPROM, the manufactured cell using thick oxide insulation between wordlines and bitlines and providing improved coupling between control gate and floating gate for programming and erasing operations.

These objects are achieved by the features of the charactererizing part of claim 1.

### SUMMARY OF THE INVENTION

In accordance with one embodiment of the invention, an electrically-erasable PROM or an EEPROM is constructed using an enhancement transistor merged with a floating-gate transistor. The floating-gate transistor has a small tunnel window adjacent the source, in a contact-free cell layout, enhancing the ease of manufacture and reducing cell size. The device has bitlines (source/drain regions) that are buried beneath relatively thick silicon oxide, allow a favorable ratio of control gate to floating gate capacitance. Programming and erasing are accomplished using the tunnel window area near the source. The window has a thinner dielectric than the remainder of the floating gate to allow Fowler-Nordheim tunneling. By using dedicated drain and ground lines, rather than a virtual-ground layout, and by using thick oxide for isolation between the bitlines of adjacent cells, the floating gate can extend onto adjacent bitlines and isolation areas, resulting in a favorable coupling ratio. Isolation between wordlines/control gates is also by thick thermal oxide in a preferred embodiment, allowing the floating gate and control gate to extend out over this oxide adjacent the channel, further improving the coupling ratio.

### BRIEF DESCRIPTION OF THE DRAWINGS

The novel features believed characteristic of the invention are set forth in the appended claims. The invention itself, however, as well as other objects and advantages thereof, will be best understood by reference to the following description of particular embodiments thereof, when read in conjunction with the accompanying drawings, in which:
Figure 1 is a plan view of a small part of a semiconductor chip having memory cells according to one embodiment;
Figures 2a-2e are elevation views in section of the semiconductor device of Figure 1, taken along the lines a-a, b-b, c-c, d-d, and e-e of Figure 1;
Figure 3 is an electrical schematic diagram of the cells of Figures 1 and 2a-2e; and
Figures 4a-4d are elevation views in section, corresponding to Figure 2a, of the device of Figures 1 and 2a-2e at successive stages in the manufacture thereof.

### DETAILED DESCRIPTION OF SPECIFIC EMBODIMENT

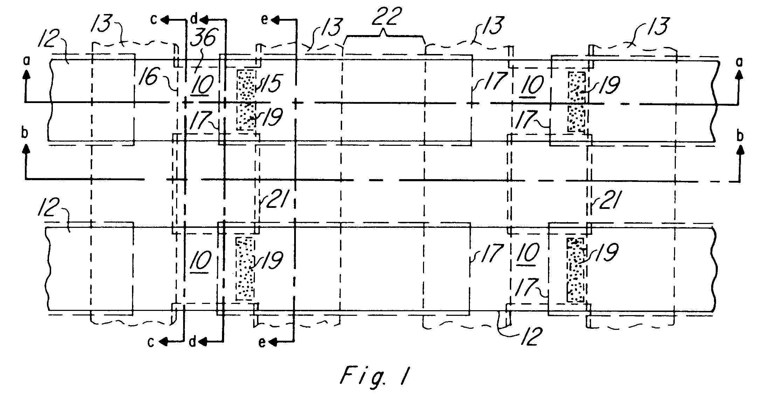

Referring now to Figures 1, 2a-2e and 3, an array of electrically-erasable, electrically-programmable memory cells 10 is shown formed in a face of a silicon substrate 11. Only a very small part of the substrate is shown in the Figures, it being understood that these cells are part of an array of a very large number of such cells. A number of wordlines/control gates 12 are formed by second-level polycrystalline silicon (polysilicon) strips extending along the face of the substrate 11, and bitlines 13 are formed beneath thick thermal silicon oxide layers 14 in the face. The buried bitlines 13 create the source region 15 and the drain region 16 for each of the cells 10. A floating gate 17 for each cell is formed by a first-level polysilicon layer extending across about half of a cell and across one bitline and extending over onto another adjacent bitline 13. Two "horizontal" or X-direction edges of the floating gate 17 for a cell are aligned with the edges of a wordline/control gate 12. A tunnel area 19 for programming and erasing is formed near the source 15 of each cell 10, and silicon oxide at this window 19 is thinner, about 10nm (100A), compared to the dielectric coating 20 of about 35 nm (350A) for the remainder of the channel beneath the floating gate 17. Programming and erasing can be performed using a relatively low externally-applied voltage when the structure of the invention is employed, with Fowler-Nordheim tunnelling requiring very little current. The coupling between layer 12 and layer 17, compared to coupling between floating gate 17 and source 15 or substrate 11, is more favorable because the floating gate extends out across the bitlines 13 and isolating area 22. Therefore, a larger fraction of the programming/erasing voltages applied between control gate 12 and source 15 will appear between floating gate 17 and source 15. The cell 10 is referred to as "contact-free" in that no source/drain contact is needed in the vicinity of cell itself.

Areas 21 of "LOCOS" thick field oxide are used to isolate cells from one another in the Y-direction. Strips 22 of LOCOS thick field oxide separate bitlines 13 between cells in the X-direction. One advantage of using LOCOS isolation between the wordlines and for source/drain isolation is that both the X and Y pitch (distance between common points of adjacent cells) as well as pitch (ratio of length to width) of the cell array can be adjusted to fit with the array decoders or other peripheral circuitry, and yet the coupling ratio remains favorable because the overlap of the control and the floating gates 17 may be adjusted over both the buried bitline oxide 14 and the LOCOS oxides 21 and 22. Another advantage is improved isolation from wordline 12 to wordline 12 and from bitline 13 to bitline 13. Furthermore, the capacitance between each bitline 13 and the substrate 11 is less than the capacitance associated with use of junction isolation such as that of the device disclosed in the foregoing application. In addition, the channel width is defined at an early stage during the processing, at which stage the surface of the substrate 11 is still fairly planar.

Note that the array of cells 10 is not of the "virtual-ground-circuit" type. That is, there are two bitlines 13 or column lines (one for source, one for drain) for each column (Y-direction) of cells, one bitline 13 being a dedicated ground, and one being the data input/output and sense line.

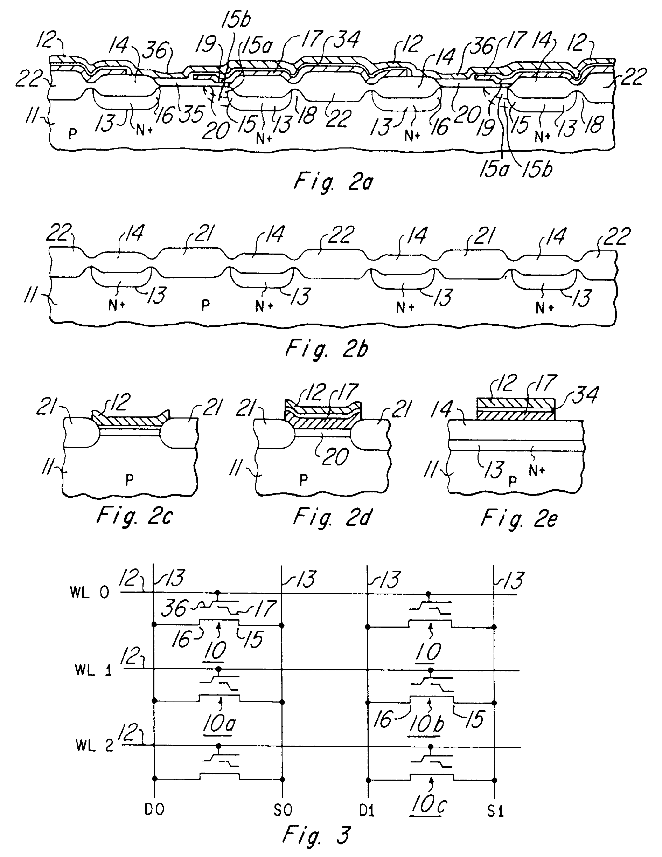

The EEPROM cells 10 of Figures 1, 2a-2e and 3 are programmed with a voltage Vpp applied to the selected wordline 12 of about +16 to +18v with respect to the source 15 of the selected cell 10. The source 15 of the selected cell 10 is at ground or other reference voltage. For example, in Figure 3, if the cell 10a is the one to be programmed, then the wordline 12 labelled WL1 is brought to +Vpp and the source labelled S0 is grounded. The voltage +Vpp can be internally generated with charge pumps on the chip, with the externally-applied supply voltage having a relatively small positive potential, perhaps +5v. The selected drain 16 (labelled D0 in this example) is allowed to float under these programming conditions so there is little or no current through the source-drain path. The Fowler-Nordheim tunneling across the tunnel oxide 19 (with thickness of about 10 nm (100A)) charges the floating gate 17 of the selected cell 10a, resulting in a shift in threshold voltage of perhaps 3-6 volts after a programming pulse approximately 10 milliseconds in length.

A selected cell is erased by applying a voltage Vee (internally-generated) of perhaps -10v on the selected wordline/control gate 12 and a voltage of about +5v on the source 15 or bitline 13. The drain 16 (the other bitline 13) is allowed to float. During erasure tunneling, electrons flow from the floating gate 17 to the source 15 because the control gate 12 is negative with respect to the source 15.

When a "flash erase" is performed (all cells 10 erased at the same time), all of the drains 16 in the array are allowed to float, all of the sources 15 are at potential Vdd, and all of the wordlines/control gates 12 are at potential -Vee.

To prevent a write-disturb condition during the programming example (cell 10a being programmed), all of the sources 15 of non-selected cells, such as cell 10b, on the same wordline WL1 of Figure 3 are held at a voltage Vbl, which is in the approximate range of 5-7 volts positive. The drains 16 of non-selected cells such as 10b are allowed to float, preventing source-drain current from flowing. The voltage Vbl applied to the source prevents the electric fields across the tunnel oxides 19 of the cells, including example cell 10b, from becoming large enough to charge the floating gates 17.

Another condition to be avoided is the "bitline stress", or deprogramming, associated with a high electric field across the tunnel oxide of a programmed cell when the source of the cell is at a potential near Vbl. To prevent this bitline stress condition, the non-selected wordlines/control gates WL0 and WL2 of Figure 3 are held at a voltage in the approximate range of 5-10 volts positive, thereby reducing the electric field across the tunnel oxide 19 of each non-selected programmed cell. A programmed cell such as 10c has a potential of about -2 to -4 volts on its floating gate, so when the voltage Vbl on the source S1 of such a cell 10c is in the range of 5-7 volts positive, the field across the tunnel oxide tends to deprogram the cell, but with a voltage in the range of 5-10 volts positive on the wordline WL2, the field is reduced. The voltage on the wordline/control gate is not so great, however, as to cause a change in threshold voltage Vt in a cell having no charge on its floating gate.

The cells described above may be read at low voltage. For example, a row of cells may be read by placing +3v on the selected wordline/control gate, zero volts on all the other wordlines/control gates, zero volts on all of the sources, and +1.5v on all of the drains. In this condition, the source-drain path of a cell will be conductive in an erased or non-programmed state (a cell with zero charge on its floating gate), i.e., storing a logic one. A programmed cell (programmed to the high-threshold state, with negative charge on the floating gate) will not conduct, i.e., storing a logic zero.

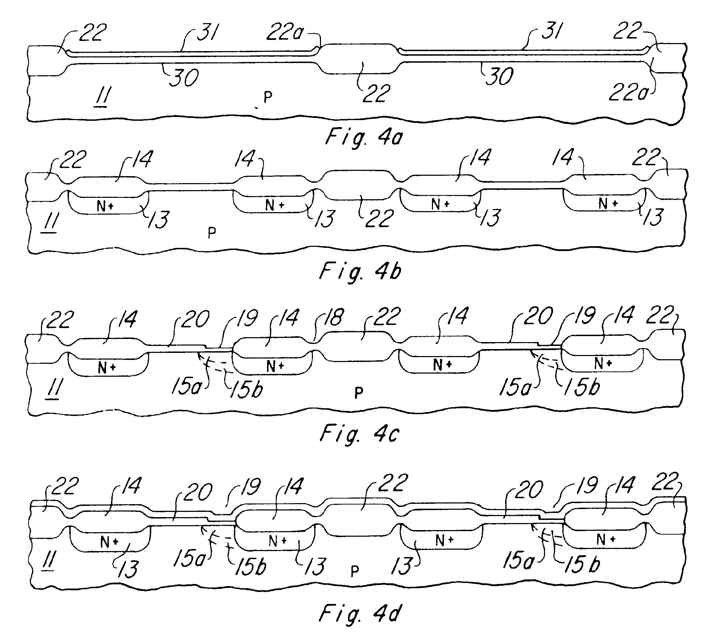

A method of making the device of Figures 1 and 2a-2e will be described in reference to Figures 4a-4d. The starting material is a slice of P-type silicon of which the substrate 11 is only a very small portion. The slice is perhaps 6 inches in diameter, while the portion shown in Figure 1 is only a few microns wide. A number of process steps would be performed to create transistors peripheral to the array, and these will not be discussed here. For example, the memory device may be of the complementary field-effect type in which N-wells and P-wells are formed in the substrate 11 as part of the process to create peripheral transistors. The first step related to the cell array of the invention is applying oxide and silicon nitride coatings 30 and 31 as seen in Figure 4a, and patterning these coatings using photoresist to leave nitride over what will be the channel regions, the sources, the drains, and the bitlines 13, while exposing the areas where the thick field oxide 21 and 22 is to be formed. A boron implant at about 8x10¹² cm⁻² dosage is performed to create a P+ channel stop beneath the field oxide 21 and 22. Then the field oxide 21 and 22 is grown to a thickness of about 900nm (9000A) by exposing to steam at about 900°C for several hours. The thermal oxide grows beneath the edges of the nitride 31, creating a "bird's beak" 22a instead of a sharp transition.

Turning now to Figure 4b, the nitride 31 is removed and, in the area where the bitlines 13 are to be formed, an arsenic implant is done at a dosage of about 6x10¹⁵ cm⁻² at 135 KeV, using photoresist as an implant mask, to create the source/drain regions and bitlines. Next, another thermal oxide is grown on the face to a thickness of about 250-350nm (2500 to 3500A) over the N+ buried bitlines, during which time a thermal oxide of about 30nm (300A) will grow over the non-doped channel areas (due to the differential oxidation occurring when heavily-doped and lightly-doped silicon areas are exposed to oxidation at the same time), to create the oxide layers 14 above the source/drain regions and bitlines 13. This oxidation is in steam at about 800 to 900°C. At the transition areas 18 where the bird's beak 22a has been formed, the edge of the originally-formed thermal oxide has masked the arsenic implant so the concentration is lower and so the oxide growth in that area is less than that of the oxide 14 or the oxide 22.

Referring now to Figure 4c, a window 19 (also seen in Figure 1) is opened in the gate oxide 20. This is done using photoresist as a mask, and etching through the oxide 20 to the bare silicon, then growing a thin oxide 19 to form tunnel window 19. During formation of the tunnel window 19 oxide, the thickness of gate oxide 20 will increase to approximately 35nm (350A).

Referring now to Figure 2a, first polysilicon layer, doped N+, is now applied to the face of the silicon slice, and a coating 34 of oxide, or oxide-nitride-oxide, is applied to separate the two polysilicon levels. The first-level polysilicon is defined using photoresist to leave elongated strips in the Y-direction, parts of which will become the floating gates 17. An oxidation, performed after the first-level polysilicon is defined, covers the edges of first-level polysilicon, and also creates the gate oxide 35 for the series enhancement transistor 36. A second polysilicon layer is deposited, doped N+, and patterned using photoresist to create the wordlines/control gates 12. At the same time as the wordlines/control gates 12 are defined, the edges of the first-level polysilicon are etched, so that the elongated X-direction edges of the floating gates are self-aligned with the edges of the control gates.

Optionally, the junction profile on the channel side of source 15 may be tailored to make certain that it terminates under the 35nm (350A) gate oxide 20, extending over the entire lower surface of window 19 and thereby maximizing the field-plate breakdown voltage of the source junction. Extension 15a or 15b of source 15 extends past the window 19 area and greatly increases the possibility that erasure will be purely by Fowler-Nordheim tunneling and not by hot carriers. For example, extension 15a may be formed to extend source 15 completely under the lower surface of window 19 by implanting a N-type impurity in window 19 prior to or after growing the 10nm (100A) coating. An alternative procedure is to include phosphorus as one of the doping materials used to form source 15, then subjecting the slice to a temperature cycle that causes the phosphorus to diffuse laterally under window 19 to form extension 15b.

## Claims

1. An electrically-erasable, electrically programmable, floating-gate memory cell (10), comprising:
a source region (15) and a drain region (16) formed in the face of a semiconductor body (11), each of said regions (15, 16) being a heavily doped region of conductivity type opposite that of underlying material of said body (11), said source region (15) being spaced from said drain region (16) on said face by a channel area,
a floating gate (17) over part of said channel area and being separated from the channel area of said face by a gate insulator (20), and
a control gate (12) extending laterally along said face, over said floating-gate (17) and over said source and drain regions (15, 16), the control gate (12) being separated from the floating gate (17) by an insulator coating (34), the control gate being aligned with edges of said floating gate (17); characterized in that
each of said regions (15, 16) is buried under a relatively thick layer of thermally grown silicon oxide (14) on said face, the width of said channel area being defined by said thermally grown oxide;
said floating gate (17) extending onto the thermally grown silicon oxide (14) over the source region (15) and on to an isolation region (22) opposite the channel region with respect to the source region and overlying a tunnel area (19) near said source region (15), the thickness of an insulator underlying said floating gate (17) at said tunnel area (14) being much less than the thickness of said gate insulator (20) beneath other areas of said floating gate (17);
said cell (10) being laterally isolated by thick oxide regions (22); and
said source and drain regions (15, 16) are included in bitlines.

2. A memory cell (10) according to claim 1 wherein said semiconductor body (11) is silicon, and said source and drain regions are N+ type.

3. A memory cell (10) according to claim 1 or 2 wherein said floating gate (17) and said control gate (12) are polycrystalline silicon layers.

4. A memory cell (10) according to any of claims 1 to 3 wherein said thermally-grown silicon oxide (14) is much thicker than said gate insulator coating (20), and wherein said field oxide (22) is thicker than said silicon oxide (14).

5. A memory cell (10) according to any of claims 1 to 4 wherein said control gate (12) is part of an elongated wordline extending along said face, and wherein said source and drain regions (15, 16) are parts of elongated bitlines (13) extending along said face perpendicular to said wordline.

6. A memory cell (10) according to any of claims 1 to 5 wherein said tunnel area (19) is positioned between said source region (15) and said drain region (16) on said face.

7. A memory cell (10) according to any of claims 1 to 5 wherein said tunnel area (19) is positioned over at least part of said source region (15).

8. A memory cell (10) according to any of claims 1 to 5 wherein said tunnel area (19) is entirely positioned above said source region (15).

9. An array of memory cells, each of said cells being a memory cell as claimed in any preceding claim.

10. An array of memory cells as claimed in claim 9, wherein the floating gate (17) of a memory cell (10) overlies a bitline (13) of an adjacent cell.

11. An array of memory cells an claimed in claim 9 or claim 10, wherein a plurality of control gates (12) are arranged to form a contiguous wordline.

12. An array as claimed in claim 11, and wherein adjacent cells are isolated in a direction perpendicular to said wordline by oxide regions (21).

## Patentansprüche

1. Elektrisch löschbare, elektrisch programmierbare Speicherzelle (10) mit schwimmendem Gate, enthaltend:
eine Source-Zone (15) und eine Drain-Zone (16) in der Fläche eines Halbleiterkörpers (11), wobei jede dieser Zonen (15, 16) eine stark dotierte Zone des Leitungstyps ist, der dem des darunterliegenden Materials des Körpers (11) entgegengesetzt ist, wobei sich die Source-Zone (15) auf der Fläche um einen Kanalbereich im Abstand von der Drain-Zone (16) befindet,
ein schwimmendes Gate (17) über einem Teil des Kanalbereichs, das von dem Kanalbereich der Fläche durch einen Gate-Isolator (20) getrennt ist, und
ein Steuer-Gate (12), das sich seitlich längs der Fläche über dem schwimmenden Gate (17) und über den Source- und Drain-Zonen (15, 16) erstreckt, wobei das Steuer-Gate (12) durch eine Isolatorbeschichtung (34) von dem schwimmenden Gate (17) getrennt ist und das Steuer-Gate mit den Rändern des schwimmenden Gates (17) in einer Linie verläuft, dadurch gekennzeichnet,
daß jede der Zonen (15, 16) unter einer relativ dicken Schicht aus thermisch gewachsenem Siliciumdioxid (14) auf der Fläche begraben ist, wobei die Breite des Kanalbereichs duch das thermisch gewachsene Oxid festgelegt ist;
daß sich das schwimmende Gate (17) auf dem thermisch gewachsenen Siliciumoxid (14) über die Source-Zone (15) und bis zu einer Isolationszone (22) bezüglich der Source-Zone gegenüber dem Kanalbereich und über einem Tunnel-Bereich (19) nahe der Source-Zone (15) erstreckt, wobei die Dicke eines unter dem schwimmenden Gate (17) liegenden Isolators bei dem Tunnelbereich (14) wesentlich kleiner als die Dicke des Gate-Isolators (20) unterhalb anderer Bereiche des schwimmenden Gates (17) ist;
daß die Zelle (10) seitlich durch dicke Oxidzonen (22) isoliert ist; und
daß die Source- und Drain-Zonen (15, 16) in Bit-Leitungen enthalten sind.

2. Speicherzelle (10) nach Anspruch 1, bei welcher der Halbleiterkörper (11) aus Silicium besteht und die Source- und Drain-Zonen vom N⁺-Typ sind.

3. Speicherzelle (10) nach Anspruch 1 oder 2, bei welcher das schwimmende Gate (17) und das Steuer-Gate (12) polykristalline Siliciumschichten sind.

4. Speicherzelle (10) nach einem der Ansprüche 1 bis 3, bei welcher das thermisch gewachsene Siliciumoxid (14) viel dicker als die Gate-Isolator-Beschichtung (20) ist und bei welcher das Feldoxid (22) dicker als das Siliciumoxid (14) ist.

5. Speicherzelle (10) nach einem der Ansprüche 1 bis 4, bei welcher das Steuer-Gate (12) Teil einer länglichen Wortleitung ist, die sich längs der Fläche erstreckt, und bei welcher die Source- und Drain-Zonen (15, 16) Teile von länglichen Bitleitungen (13) sind, die sich längs der Fläche senkrecht zu der Wortleitung erstrecken.

6. Speicherzelle (10) nach einem der Ansprüche 1 bis 5, bei welcher der Tunnelbereich (19) zwischen der Source-Zone (15) und der Drain-Zone (16) auf der Fläche angeordnet ist.

7. Speicherzelle (10) nach einem der Ansprüche 1 bis 5, bei welcher der Tunnelbereich (19) über wenigstens einem Teil der Source-Zone (15) angeordnet ist.

8. Speicherzelle (10) nach einem der Ansprüche 1 bis 5, bei welchem der Tunnelbereich (19) vollständig über der Source-Zone (15) angeordnet ist.

9. Matrix aus Speicherzellen, wobei jede der Zellen eine Speicherzelle gemäß einem der vorhergehenden Ansprüche ist.

10. Matrix aus Speicherzellen nach Anspruch 9, bei welcher das schwimmende Gate (17) einer Speicherzelle (10) eine Bitleitung (13) einer angrenzenden Zelle überdeckt.

11. Matrix aus Speicherzellen nach Anspruch 9 oder Anspruch 10, bei welcher mehrere Steuer-Gates (12) zur Bildung einer zusammenhängenden Wortleitung angeordnet sind.

12. Matrix nach Anspruch 11, bei welcher banachbarte Zellen in einer Richtung senkrecht zur Wortleitung durch Oxidzonen (21) isoliert sind.

## Revendications

1. Cellule de mémoire (10) à grille flottante électriquement programmable et électriquement effaçable, comprenant :
une région de source (15) et une région de drain (16) formées dans la face d'un corps de semi-conducteur (11), chacune desdites régions (15,16) étant une région fortement dopée d'un type de conductivité opposé à celui d'un matériau sous-jacent dudit corps (11), ladite région de source (15) étant espacée de ladite région de drain (16) sur ladite face par une zone de canal,
une grille flottante (17) au dessus d'une partie de ladite zone de canal et séparée de ladite zone de canal de ladite face par un isolant de grille (20), et
une grille de commande (12) s'étendant latéralement le long de ladite face, au dessus de la grille flottante (17) et au dessus desdites réglons de source et de drain (15,16), la grille de commando (12) étant séparée de la grille flottante (17) par une couche isolante (34), la grille de commande étant alignée avec les bords de ladite grille flottante (17) ; caractérisée en ce que
chacune desdites régions (15,16) est enterrée sous une couche relativement épaisse d'un oxyde de silicium obtenu par croissance thermique (14) sur ladite face, la largeur de ladite zone de canal étant définie par ledit oxyde obtenu par croissance thermique ;
ladite grille flottante (17) s'étendant sur l'oxyde de silicium obtenu par croissance thermique (14) au dessus de la région de source (15) et sur une région d'isolement (22) opposée à la région de canal par rapport à la région de source et recouvrant une zone de tunnel (19) proche de ladite région de source (15), l'épaisseur d'un isolant situé en dessous de ladite grills flottante (17) au niveau de ladite zone de tunnel (14) étant plus faible que l'épaisseur dudit isolant de grille (20) au dessous des autres zones de ladite grille flottante (17);
ladite cellule (10) étant isolée latéralement par des régions d'oxyde épaisses (22) ; et
lesdites régions de source et de drain (15,16) sont incluses dans des lignes de bits.

2. Cellule de mémoire (10) selon la revendication 1, dans laquelle ledit corps de semi-conducteur (11) est en silicium, et lesdites régions de source et de drain sont de type N+.

3. Cellule de mémoire (10) selon l'une des revendications 1 et 2, dans laquelle ladite grille flottante (17) et ladite grille de commande (12) sont des couches de silicium polycristallin.

4. Cellule de mémoire (10) selon l'une quelconque des revendications 1 à 3, dans laquelle ledit oxyde de silicium obtenu par croissance thermique (14) est plus épais que ladite couche isolante de grille (20), et dans laquelle ledit oxyde de champ (22) est plus épais que ledit oxyde de silicium (14).

5. Cellule de mémoire (10) selon l'une quelconque des revendications 1 à 4, dans laquelle ladite grille de commande (12) fait partie d'une ligne de mots allongée s'étendant le long de ladite face, et dans laquelle lesdites régions de source et de drain (15,16) sont des parties de lignes de bits allongées (13) s'étendant le long de ladite face perpendiculaire à ladite ligne de mots.

6. Cellule de mémoire (10) selon l'une quelconque des revendications 1 à 5, dans laquelle ladite zone de tunnel (19) est positionnée entre ladite région de source (15) et ladite région de drain (16) sur ladite face.

7. Cellule de mémoire (10) selon l'une quelconque des revendications 1 à 5, dans laquelle ladite zone de tunnel (19) est positionnée au dessus d'au moins une partie de ladite région de source (15).

8. Cellule de mémoire (10) selon l'une quelconque des revendications 1 à 5, dans laquelle ladite zone de tunnel (19) est entièrement positionnée au dessus de ladite région de source (15).

9. Réseau de cellules de mémoire, chacune desdites cellules étant une cellule de mémoire selon l'une quelconque des revendications précédentes.

10. Réseau de cellules de mémoire selon la revendication 9, dans lequel la grille flottante (17) d'une cellule de mémoire (10) recouvre une ligne de bits (13) d'une cellule adjacente.

11. Réseau de cellules de mémoire selon la revendication 9 ou la revendication 10, dans lequel une pluralité de grilles de commande (12) sont disposées de maniére à former une ligne de mots continue.

12. Réseau selon la revendication 11, dans lequel les cellules adjacentes sont isolées selon une direction perpendiculaire à ladite ligne de mots par des régions d'oxyde (21).
